# EUROPEAN PATENT SPECIFICATION

(11) **EP 0 640 610 B1**
(45) Date of publication and mention of the grant of the patent: **19.04.2000**
(21) Application number: 94303593.1
(22) Date of filing: 19.05.1994
(51) Int. Cl.: C07F 5/00, C23C 16/30

(54) **Liquid indium source**
Flüssigindiumquelle
Source liquide d'indium

(30) Priority: 27.07.1993 US 97821
(43) Date of publication of application: 01.03.1995
(73) Proprietor: Morton International, Inc., Chicago, Illinois 60606-1596 (US)
(72) Inventor: Kanjolia, Ravindra K., North Andover, Massachusetts 01845 (US); Hui, Benjamin C., Peabody, Massachusetts 01960 (US)
(74) Representative: Bankes, Stephen Charles Digby

(56) References cited:
- EP-A- 0 181 706
- WO-A-93/03196
- US-A- 4 847 399

## Description

The present invention is directed to a method of providing a uniform dosimetry of vapor phase trimethylindium for epitaxial growth processes, such as metalorganic chemical vapor deposition (MOCVD).

The most commonly used indium compound for MOCVD or other epitaxial deposition processes is trimethylindium. Materials produced by epitaxial growth using trimethylindium as an indium source include, for example InP, InGaAs, InGaAlP, InGaAsP, InGaAs/GaAs/AlGaAs, InAs, InSb and InAsBi.

A well-known inherent disadvantage of trimethylindium as an indium source is the fact that it is a solid at room temperature. Liquid sources of organometallic vapors are preferred to solid sources because a gas stream having a substantially constant partial pressure of organometallic vapors can be produced merely by bubbling carrier gas through the liquid at a constant rate. With solids, on the other hand, the surface area is constantly changing as the organometallic source is vaporized. Furthermore, solids, such as trimethylindium, tend to recondense on surfaces of the gas pathway, further increasing the difficulty of providing a uniform partial pressure of the organometallic compound.

Trimethylindium, being a solid, is an anomaly relative to other trialkylindiums, as C₂-C₅ alkylindiums are liquids at room temperature. This anomaly is the result of trimethylindium existing as a tetramer at room temperature, whereas other trialkylindiums are monomers. However, from the standpoint of providing a sufficiently high vapor pressure for epitaxial growth applications, trimethylindium, having a relatively high vapor pressure, tends to be preferred.

Several approaches have been taken to eliminate complications due to uneven mass flow when using trimethylindium. Some of these include reverse flow of carrier gas through the bubbler; packing the trimethylindium in inert material, such as Teflon beads, in the bubbler; use of two or more trimethylindium bubblers in series; and "solution trimethylindium" where the trimethylindium is dissolved and/or suspended in a high boiling amine or high boiling hydrocarbon.

Those approaches in which the trimethylindium remains in solid phase, reduce, but do not eliminate, uneven mass flow.

While trimethylindium may be dissolved in amine, its solubility is low, typically about 20%, requiring a large volume of trimethylindium source. Amines complex with trimethylindium, advantageously breaking up the tetramer, but disadvantageously tying up trimethylindium. Because epitaxial growth applications require a source with very minimal high vapor pressure impurities, amine solvents are used which are highly purified, particularly with respect to volatile impurities. Nevertheless, if impurities are present, they may react with the trimethylindium, producing new, more volatile impurities. Also, even high boiling amines are entrained in the gas stream to some extent and may undesirably introduce nitrogen into the material which is being produced.

High boiling hydrocarbons avoid the problem of nitrogen. However, trimethylindium is even less soluble in hydrocarbons than amines, and the trimethylindium is more dispersed than dissolved in hydrocarbon media. Because hydrocarbons do not break up the tetramer, problems with deposition of trimethylindium in the gas pathway remain. Also, as with amines, there is the possibility that impurities will react with trimethylindium to produce volatile impurities.

U.S. Patent No. 4,720,560 approaches the problem by mixing two moles of trimethylindium with a mole of triethylindium to produce ethyldimethylindium by the reversible reaction: ${\text{2 Me}}_{\text{3}} {\text{In + Et}}_{\text{3}} {\text{In → 3 EtMe}}_{\text{2}} \text{In.}$The desired indium source in this approach is not trimethylindium, but ethyldimethylindium. Because the equilibrium is temperature-dependent with the equilibrium shifting to the right at lower temperatures, it is advised to maintain the mixture at a temperature below room temperature, e.g., at about 10°C. Such a lowered temperature may be disadvantageous if high vapor pressures are required for the crystal growth. Increasing the temperature may potentially cause the above equilibrium to shift to the left, and cause the ethyldimethylindium to dispreportionate.

WO-A-93/03196 discloses a method for depositing a metal, originating from a precursor such as trimethylindium, on a substrate, which process comprises transporting precursor material, vaporized from said precursor, to the substrate via a carrier gas. The carrier gas is loaded with said precursor at a certain temperature, at which the precursor is normally solid, by passing the gas through a liquid containing the precursor.

In accordance with the present invention, a liquid source of indium comprises trimethylindium dissolved in a C₃-C₅ trialkylindium or mixture of C₃-C₅ trialkylindiums. Gas, such as hydrogen or helium, bubbled through this source entrains trimethylindium in monomeric form.

Preferred embodiments of the invention will now be described with reference to the accompanying drawings wherein:
FIG. 1 is a diagrammatic illustration of apparatus used to deliver vaporized trimethylindium in the Example below.
FIG 2 is a graph showing grams of trimethyl indium delivered charged against hours of delivery in the Example below.

Trimethylindium is highly soluble in high-boiling trialkylindiums, such as C₃-C₅ trialkylindiums. As is the case with the trimethylindium/triethylindium system, it is believed that a reversible reaction occurs when trimethylindium is introduced into a higher trialkylindium: ${\text{Me}}_{\text{3}} {\text{In + (C}}_{\text{3}} {\text{-C}}_{\text{5}} {\text{alkyl)}}_{\text{3}} {\text{In → Me}}_{\text{x}} {\text{(C}}_{\text{3}} {\text{-C}}_{\text{5}} {\text{alkyl)}}_{\text{(3-x)}} \text{In;}$where x = 1 or 2. Thus, up to two moles of trimethylindium can be dissolved into 1 mole of C₃-C₅ trialkylindium. For example, 320 grams of trimethylindium may be dissolved into 286 grams of tributylindium.

Although tripropylindiums may be used as solvents, butylindiums, such a tri n-butylindium (b.p. 85-6°C/0.1 mm Hg) and triisobutylindium (b.p. 71-2°C/0.05 mm Hg) (or mixtures of these isometric tributylindiums) are preferred because of their higher boiling point. The solvents are preferably highly purified, e.g., to five 9's purity. An advantage of trialkylindiums as solvent for trimethylindium, relative to amines or hydrocarbons, are that any trace impurities, which in the case of the amine or hydrocarbon might react with trimethylindium to produce volatile impurities, would have already reacted with the higher trialkylindium to produce either a non-volatile impurity or a volatile impurity which would be removed in the purification process. Also, unlike amines which might introduce nitrogen into the material being deposited, the higher trialkylindiums introduce no element in addition to those present in trimethylindium. Like amine solvents, trialkylindium solvents break the tetrameric trimethylindium into monomeric form, which is the form that is vaporized.

Unlike the trimethylindium/triethylindium system described in U.S. Patent No. 4,720,560, essentially the only volatile species is trimethylindium. Also, at higher temperatures, where a higher vapor pressure of trimethylindium is achieved, the equilibrium shifts to the left, enhancing the amount of trimethylindium available for entrainment by the carrier gas. As a result, the bubbler may be maintained at higher temperatures, 17-40°C being a typical temperature for the bubbler. As a consequence of there being a single volatile species which is constantly replenished by the equilibrium of the reaction, the amount of trimethylindium entrained by a carrier gas tends to be very constant over time, until trimethylindium is substantially depleted, whereupon a rather sharp drop-off may occur. By depositing in the trimethylindium concentration range where the mass flow of trimethylindium is constant, more uniform epitaxial growth may be achieved.

To provide the most constant mass flow of trimethylindium, it is advantageous to initially provide a saturated or nearly saturated solution of trimethyl indium.

Suitable carrier gases are those which are non-reactive with the trimethylindium or with the trialkylindium solvent. Hydrogen is the preferred carrier gas, but other gases, such as helium or argon may be used.

### Example

To illustrate the invention, the following experiment was conducted. Inside a nitrogen filled glove box, 18 grams of trimethylindium (0.11 mol) was dissolved in 15 grams of tri n-butylindium (0.05 mol) in a stainless steel bubbler. A clear colorless solution resulted which by NMR showed the formulation of BuMe₂In. Further dissolution of trimethylindium (TMI) was not possible as it started to settle down. The density of this solution was approximately 2 g/mL at room temperature.

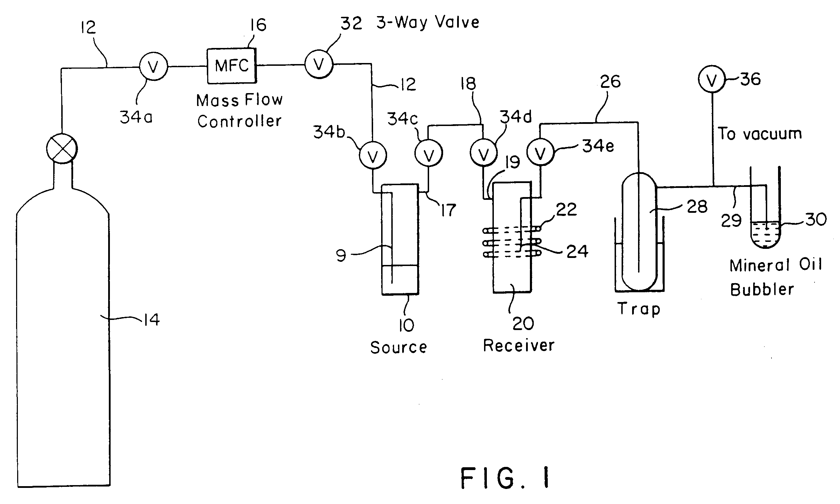

The apparatus used in the experiment to determine the flow behavior of this solution is shown in Figure 1. The inlet 9 of a stainless steel (SS) bubbler (source) 10 containing Bu₃In/Me₃In solution was connected through line 12 to a tank 14 of semiconductor grade N₂ via a mass flow controller 16. The outlet 17 of the bubbler 10 was connected through line 18 to the outlet 19 of another stainless steel bubbler (receiver) 20. (The second bubbler 20 is used in reverse orientation from normal for this experiment; thus flow from outlet 17 of bubbler 10 to outlet 19 of bubbler 20.) The receiver bubbler 20 was cooled by a coil condenser 22 maintained at -15 to -20°C. The inlet 24 of this receiver was connected through line 26 to a dry ice-cooled trap 28 to condense the fugitive vapors from the receiver 20. The trap 28 was connected through line 29 to a mineral oil bubbler 30 to maintain a by-pass of N₂ gas.

Additional features of the apparatus include a three-way valve in line 12 used to evacuate the space between the inlet valve 34a of the nitrogen bubbler 10, several valves 34a, 34b, 34c, 34d, 34e throughout the line for set-up, and a vacuum connected to line 29 to evacuate the trap 30 and the space up to the receiver valve 34e after connections are made.

The source bubbler 10 was maintained at about 20°C while the carrier gas was passed through it at a rate of 500 SCCM. Such a high flow rate was chosen to deplete the contents of the bubbler 10 in a relatively less amount of time. It was observed that the saturation of the carrier gas with TMIn was approximately 40%. This is perhaps due to the high flow rate and somewhat lower source temperature. The saturation of the carrier gas can easily be increased to >80% by lowering the flow rate and increasing the source temperature to 30-40°C.

The amount of trimethylindium carried was monitored by the weight loss in the source bubbler. NMR spectra were obtained periodically to identify the material in the source bubbler and receiver bubbler. The data indicated that trimethylindium alone was carried through until toward the end. This has been confirmed by the gradual reduction of methyl peaks in the source bubbler. The receiver contained a white solid-trimethylindium-as evidenced by its NMR.

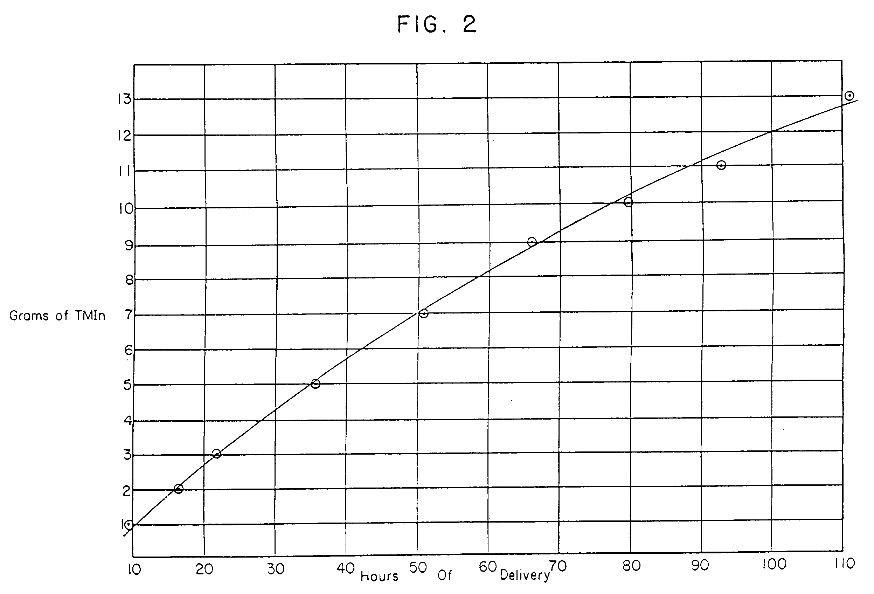

The dosimetry of trimethylindium is shown in figure 2. A linear relationship exists up to 110 hours with a gradual slow down in the delivery of TMIn toward the end. In this experiment, approximately 13 grams of the total 15 grams of TMIn (3.0 grams was consumed for NMR samples) was transported in a very uniform manner corresponding to 85% of the initial amount of TMIn. The delivery of TMIn did not drop off even at this stage and showed no erratic delivery behavior. The NMR spectrum indicated a n-Bu₃In rich solution with >80% less TMIn than the initial mixture. These data confirm that TMIn could be consistently delivered for an extended period of time with a uniform rate. Furthermore, it is believed that this uniform delivery can be further enhanced by suspending additional TMIn in this solution.

## Claims

1. A method of providing vapor phase trimethylindium comprising dissolving trimethylindium in a C₃-C₅ trialkylindium solvent to produce a solution and entraining trimethylindium from said solution with a carrier gas.

2. A method according to claim 1 wherein said solvent comprises tri n-butylindium, triisobutylindium or a mixture thereof.

3. A method according to claim 1 or claim 2 wherein said trimethylindium is dissolved at a molar ratio relative to said solvent of at least 0.05:1.

4. A solution comprising a C₃-C₅trialkylindium solvent and trimethylindium dissolved therein.

5. A solution according to claim 4 wherein said trimethylindium is dissolved at a molar ratio relative to said solvent of at least 0.05:1.

## Patentansprüche

1. Verfahren zur Gewinnung von Trimethylindium in der Dampfphase, bei dem man Trimethylindium in einem C₃-C₅-Trialkylindiumlösungsmittel unter Erzeugung einer Lösung auflöst und Trimethylindium aus dieser Lösung mit einem Trägergas herausschleppt.

2. Verfahren nach Anspruch 1, bei dem das Lösungsmittel Tri-n-butylindium, Triisobutylindium oder ein Gemisch hiervon umfaßt.

3. Verfahren nach Anspruch 1 oder 2, bei dem das Trimethylindium in einem Molverhältnis in bezug auf das Lösungsmittel von wenigstens 0,05 : 1 gelöst wird.

4. Lösung, die ein C₃-C₅-Trialkylindiumlösungsmittel und darin gelöst Trimethylindium umfaßt.

5. Lösung nach Anspruch 4, bei der das Trimethylindium in einem Molverhältnis in bezug auf das Lösungsmittel von wenigstens 0,05 : 1 gelöst ist.

## Revendications

1. Un procédé de production de triméthylindium en phase vapeur englobant la dissolution du triméthylindium dans un solvant au trialkylindium C₃-C₅ pour produire une solution, et entraînement du triméthylindium hors de ladite solution avec un gaz véhiculeur.

2. Un procédé selon la revendication 1, selon lequel ledit solvant englobe le tri n-butylindium, le triisobutylindium ou un mélange de ceux-ci.

3. Un procédé selon la revendication 1 ou 2, selon lequel ledit triméthylindium est dissous à un rapport molaire minimum de 0,05:1 relativement audit solvant.

4. Une solution englobant un solvant au trialkylindium C₃-C₅ et le triméthylindium dissous à l'intérieur de celle-ci.

5. Une solution selon la revendication 4, dans laquelle ledit triméthylindium est dissous à un rapport molaire minimum de 0,05:1 relativement audit solvant.
